# EUROPEAN PATENT APPLICATION

(11) **EP 4 421 832 A1**
(43) Date of publication of application: **28.08.2024**
(21) Application number: 23157823.8
(22) Date of filing: 21.02.2023
(51) Int. Cl.: H01F 27/02, F04D 25/08, F04F 5/16, H05K 7/20, H01F 27/12

(54) **A TRANSFORMER ARRANGEMENT**

(71) Applicant: Hitachi Energy Ltd, 8050 Zürich (CH)
(72) Inventor: HOSAIN, Lokman, 724 79 Västerås (SE); SAND, Ulf, 724 63 Västerås (SE); BEL FDHILA, Rebei, 724 76 Västerås (SE)
(74) Representative: Valea AB

(57) **Abstract**

A transformer arrangement (12) comprising an airflow generator (1) and a transformer (10) provided with an oil-to-air external heat exchanger (11), the airflow generator (1) being configured to discharge air towards the oil-to-air heat exchanger (11). The airflow generator (1) comprises an electrically powered ducted fan (2), a fluid conduit (5), an air multiplier (7) for discharging air along a first axis (A), and an airflow redistribution device (14, 14a, 14b, 14c, 14d) axially displaced from the air multiplier (7) along a first axis (A), downstream of the air multiplier (7). The airflow redistribution device (14, 14a, 14b, 14c, 14d) is configured to redirect airflow from regions of higher speed airflow discharged from the air multiplier (7) to regions of lower speed airflow discharged from the air multiplier (7), thereby promoting a more even distribution of airflow speeds downstream of the airflow redistribution device (14, 14a, 14b, 14c, 14d).

## Description

### TECHNICAL FIELD

The present disclosure relates to an airflow generator, and to a transformer assembly comprising such an airflow generator for cooling of a heat exchanger provided externally of the transformer for cooling of the transformer.

### BACKGROUND

A power transformer is equipment used in an electric grid of a power system. Power transformers transform voltage and current in order to transport and distribute electric energy. Power transformers involve high currents; therefore, production of heat is inevitable. This heat propagates in oil inside a transformer tank. It is important to release this heat to the surroundings for the normal operation of transformers. An important part of oil-cooling is carried out by placing external devices by the transformer, such as radiators, cooler banks etc., through which the transformer oil is circulated and get cooled. State-of-the art air-cooling for a transformer is performed using conventional fans, i.e., bladed fans, or using natural convection. The state-of-the-art cooling systems using bladed fans typically produce high noise, have complex structure, are heavy, and are difficult to maintain. For high-power transformers, natural convection is not enough to cool the transformer, and therefore, forced cooling is needed.

External transformer cooling generally uses a one or more radiators external to the transformer, said radiators allowing oil to circulate from the transformer and out to the radiators, where heat is dissipated from the oil to surrounding ambient air. The cooling process typically uses natural convection or forced convection to move ambient air past the radiator.

This disclosure concerns cooling systems using forced convection. Forced convection is typically achieved using one or more large fans blowing air through or onto the radiator(s). Cooling efficiency is dependent on airflow rate and consequently on the power consumption of the fans.

Accordingly, an object of the present disclosure is to provide a compact and power-efficient airflow generator cooling arrangement for a transformer.

### SUMMARY

According to a first aspect of the present disclosure, these and other objects are achieved by a transformer arrangement as defined in claim 1, with alternative embodiments defined in dependent claims. The transformer arrangement comprises an airflow generator and a transformer provided with an oil-to-air heat exchanger. The airflow generator is configured to discharge air towards the oil-to-air heat exchanger and comprises an electrically powered ducted fan provided with an inlet and an outlet, a fluid conduit; an air multiplier for discharging air along a first axis, the air multiplier comprising an inlet and an outlet; and an airflow redistribution device that is axially displaced from the air multiplier along the first axis, downstream of the air multiplier. The air multiplier comprises an inlet and an outlet, the fluid conduit fluidly connects the outlet of the ducted fan to the inlet of the air multiplier, and the airflow redistribution device is configured to redirect airflow from regions of higher speed airflow discharged from the air multiplier to regions of lower speed airflow discharged from the air multiplier, thereby promoting a more even distribution of airflow speeds downstream of the airflow redistribution device.

Local airflow rates are generally more evenly distributed further away from the air multiplier. The herein disclosed airflow generator, comprising the air flow redistribution device, provides a more even distribution of airflow rates closer to the airflow generator, thereby allowing the airflow generator to be positioned closer to an object to be cooled by the airflow. This enables a reduction of the size of a product incorporating the airflow generator for cooling of the product.

The fan provides an airflow into the air multiplier. The ducted nature of the fan enables it to efficiently pressurize the fluid conduit. By providing the airflow generator with an air multiplier, a much larger amount of air than the amount of air supplied by the fan, is discharged towards the oil-to-air heat exchanger. This reduces power consumption as compared to use of conventional fans directly blowing air against the oil-to-air heat exchanger. Also, noise emitted from the fan and air multiplier combination may be lower than a corresponding noise level emitted from a fan achieving the same airflow towards the heat exchanger.

Air multipliers are often configured as rings with a central opening through which air is moved along by air discharged from the air multiplier. The flow velocity of air flowing through the ring is higher closer to the ring and lower further from the ring. For example, if an air multiplier is configured as a ring, the generated air flow from the air multiplier can have an approximately cylindrical shape with low speed in the core of the cylinder and much higher speeds at the edges of the cylinder. Thus, a cooling pattern delivered by the air flow is far from being uniform, such that some areas of the heat exchanger have a higher heat transfer coefficient whereas other areas, receiving an air with lower velocity, have a lower heat transfer coefficient and thus not perform sufficient cooling.

By providing the airflow generator with the airflow redistribution device, as claimed, a more even distribution of airflow speeds downstream of the airflow redistribution device is achieved closer to the air multiplier. This enables the airflow generator to be positioned closer to the heat exchanger and thus reduces the total size of the transformer arrangement.

The airflow redistribution device may comprise various shapes and configurations that facilitate redirecting the airflow from regions of higher speed airflow discharged from the air multiplier to regions of lower speed airflow discharged from the air multiplier.

The airflow redistribution device may comprise a ring-shaped profile extending around the first axis.

The airflow redistribution device may comprise a plurality of differently sized ring-shaped profiles extending around the first axis.

Each ring-shaped profile may have a diameter which is gradually decreasing in a discharge direction along the first axis.

The airflow redistribution device may comprise an array of air deflector members distributed transversely to the first axis such that the air deflector members jointly define air passages between the air deflector members.

The air deflector members may be configured such that a plurality of the air passages extend at an angle to the first axis A in the range of 1-45 degrees. Such a configuration of the air passages facilitates redirecting the airflow from regions of higher speed airflow discharged from the air multiplier to regions of lower speed airflow discharged from the air multiplier.

In some cases, the air deflector members are rectangular-shaped plates.

By including the air flow redistribution device that is configured to redirect airflow from regions of higher speed airflow discharged from the air multiplier to regions of lower speed airflow discharged from the air multiplier, the air flow discharged from the air multiplier is homogenized and becomes sufficiently wider to thereby cover a larger surface of the heat exchanger, as compared to a transformer arrangement without the air flow redistribution device.

### BRIEF DESCRIPTION OF THE DRAWINGS

Fig. 1 shows a prior-art airflow generator comprising an air multiplier.
Fig. 2 shows a side view of the prior-art airflow generator also shown in Fig. 1 (shown without the ducted fan and without the fluid conduit).
Fig. 3 shows a transformer arrangement without an airflow redistribution device.
Fig. 4 shows a transformer arrangement comprising an airflow redistribution device according to the present disclosure, and a transformer provided with an external oil-to-air heat exchanger.
Fig. 5 shows a perspective view of a cross-section of the air multiplier. All air multipliers described herein are based on the same general cross-sectional design.
Fig. 6 shows a perspective view of the air multiplier and an example of an airflow redistribution device according to the present disclosure.
Fig. 7a shows a perspective view of the air multiplier and another example of an airflow redistribution device according to the present disclosure.
Fig. 7b shows a cross-sectional side view of the airflow redistribution device of Fig. 7a.
Fig. 8a shows a perspective view of the air multiplier and another example of an airflow redistribution device according to the present disclosure.
Fig. 8b shows a cross-sectional side view of the airflow redistribution device of Fig. 8a.
Fig. 9a shows an example of a non-circular ring-shape of an airflow redistribution device according to the present disclosure.
Fig. 9b shows a cross-sectional side view of the airflow redistribution device of Fig. 9a.

All figures are schematical illustrations and are not drawn to scale.

### DETAILED DESCRIPTION

Embodiments of the present disclosure will hereinafter be explained with reference to the appended drawings.

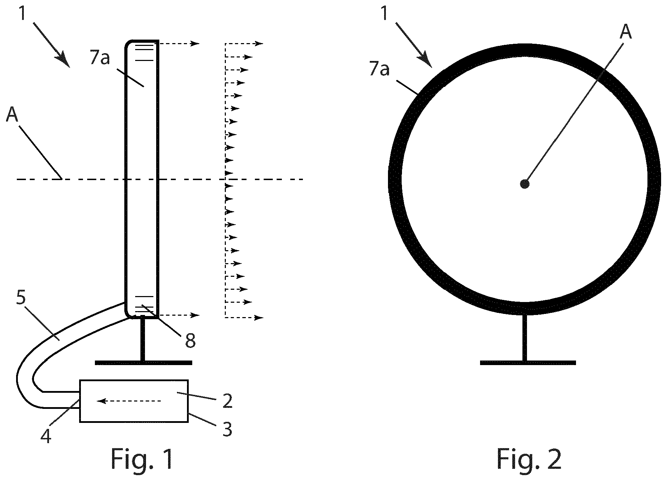

Fig. 1 shows a prior art airflow generator comprising an electrically powered ducted fan 2 provided with an inlet 3 and an outlet 4. The airflow generator 1 further comprises a fluid conduit 5 and an air multiplier 7a for discharging air along a first axis A. The air multiplier 7a comprises an inlet 8 and an outlet 9. The fluid conduit 5 fluidly connects the outlet 4 of the ducted fan 2 to the inlets 8 of the air multiplier 7a.

The term air multiplier is used in the prior art and thus should be known to the skilled person. Air multipliers are nozzles typically used in bladeless fans. Herein, the term air multiplier may to refer to any type of air discharge device/nozzle designed to discharge air through an outlet, typically in the form of one or more elongate slits, such that air around the discharge device is brought along by the air discharged from the outlet at a rate of at least 5-15 times the amount of air discharged by the outlet.

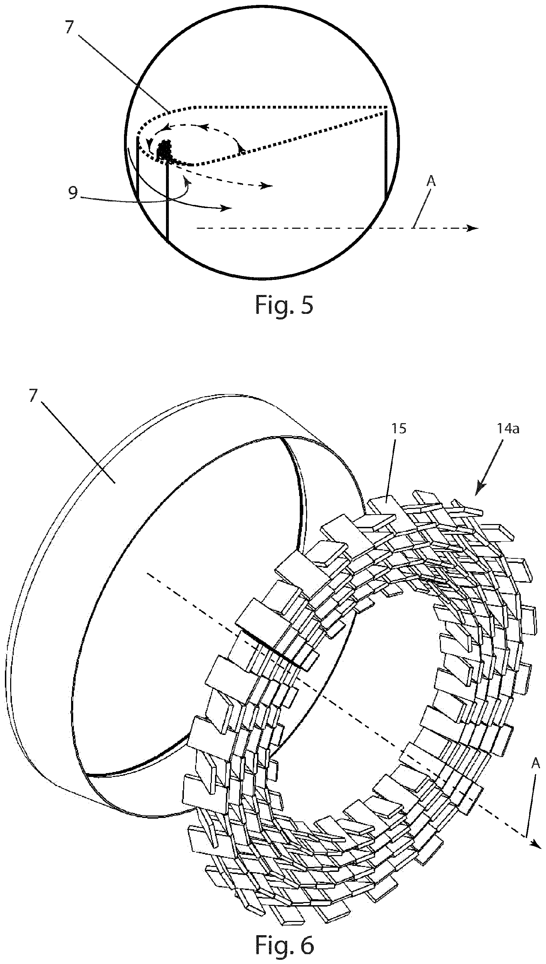

Another term which could be used instead of air multiplier is Coand 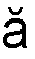 effect air flow multiplier. Such air discharge devices can vary greatly in design but are often shaped like an extruded hollow profile, an example of which is shown in Fig. 5, although any other suitable shape is possible. The profile usually has an elongate cross-sectional shape, and the outlet is typically configured to discharge air in a direction along a first axis extending along the length of the elongate cross-sectional shape, as shown in Fig. 5. The profile may have an aerodynamic foil shape. The outlet may be provided anywhere suitable along the length of the cross-sectional shape of the profile, such as at a leading portion of the profile (facing incoming ambient air as in Fig. 5), or at a trailing portion of the profile, facing in the discharge direction of the air multiplier, or somewhere between the leading and trailing portions of the profile. The profile may be straight but is typically bent to form a ring circumscribing an inner cross-sectional area of the air multiplier.

In Fig. 2, the airflow generator 1, also shown in Fig. 1, is shown without the ducted fan 2 and without the fluid conduit 5.

The fan 2 provides an airflow into the air multiplier 7a. The ducted nature of the fan 2 enables it to efficiently pressurize the fluid conduit 5. By providing the airflow generator 1 with an air multiplier 7a, a much larger amount of air than the amount of air supplied by the fan 2, is discharged towards the oil-to-air heat exchanger (not shown in Figs. 1 and 2). Depending on the specific design of the air multiplier 7a, the airflow generator 1 may thus be able to output an airflow of ten to fifteen times the airflow produced by the fan 2. This reduces power consumption as compared to use of conventional fans directly blowing air against an object to be cooled, such as an oil-to-air heat exchanger provided on a transformer.

Such air multipliers 7a are typically configured as rings with a central opening through which air is moved along by air discharged from the air multiplier along the first axis A. The flow velocity of air flowing through the ring is higher closer to the ring and lower further from the ring, as indicated by the broken-line arrows in Fig. 1 whose lengths schematically indicate a speed of local airflow.

To improve energy efficiency at cooling of a transformer, the present disclosure provides a transformer arrangement comprising, in addition to the air multiplier, an airflow redistribution device axially displaced from the air multiplier along the first axis A, downstream of the air multiplier. The airflow redistribution device is configured to redirect airflow from regions of higher speed airflow discharged from the air multiplier to regions of lower speed airflow discharged from the air multiplier, thereby promoting a more even distribution of airflow speeds downstream of the airflow redistribution device.

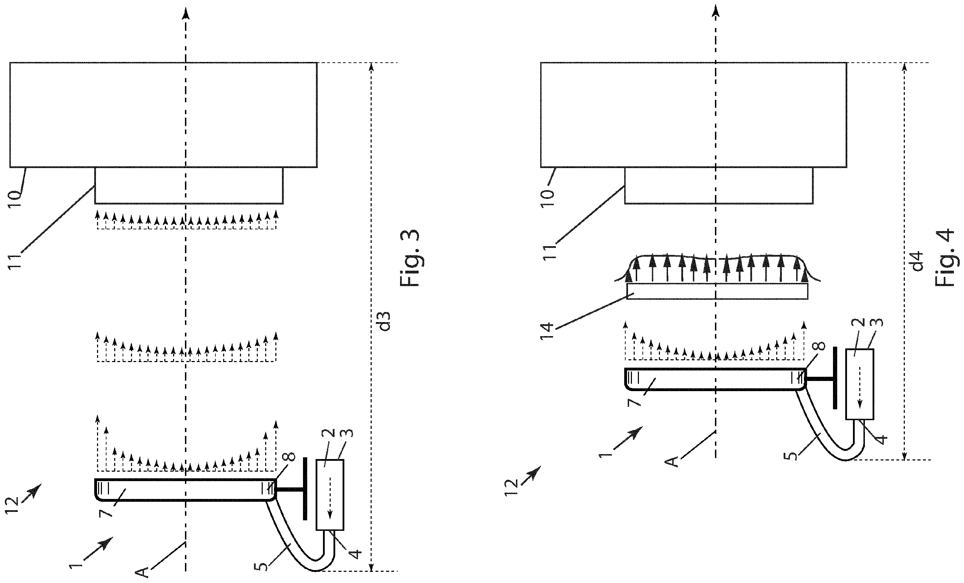

Fig. 3 schematically illustrates, for comparison purposes, a transformer arrangement 12 comprising an air flow generator 1, corresponding to air flow generator 1 of Figs. 1 and 2 described above, the transformer arrangement 12 being without an air flow redistribution device. The transformer arrangement 12 further comprises a transformer 10 provided with an oil-to-air external heat exchanger 11. The airflow generator 1 is configured to discharge air towards the oil-to-air heat exchanger 11. The oil-to-air external heat exchanger 11 is external in the sense that it is mounted externally on the transformer 10, thereby being able to radiate and conduct heat to surrounding air. Typically, oil from inside the transformer 10 is pumped through the oil-to-air heat exchanger 11, wherein the oil transports heat generated within the transformer 10 out to the heat exchanger 11, such that the airflow from the airflow generator 1 cools the heat exchanger 11.

Similar to Fig. 1, Fig. 3 illustrates that the flow velocity of air flowing through the airflow generator 1 is higher closer to the walls of the airflow generator 1 and lower further from the airflow generator 1, as indicated by the broken-line arrows in Fig. 3, where the length of the arrows schematically indicates a speed of local airflow. Thus, Fig. 3 shows regions of higher speed airflow that are closer to the walls of the air multiplier 7, and regions of lower speed airflow that are further away from the walls of the air multiplier 7 and are closer to the first axis (A).

Fig. 4 schematically illustrates a transformer arrangement 12 proposed by the present disclosure. The transformer arrangement 12 comprises an airflow generator 1 and also includes an air flow redistribution device 14 in accordance with the present disclosure. As in the example of Fig. 3, the transformer arrangement 12 of Fig. 4 comprises a transformer 10 provided with an oil-to-air external heat exchanger 11. The airflow generator 1 of Fig. 4 is configured to discharge air towards the oil-to-air heat exchanger 11.

As shown in Fig. 4 with broken line arrows whose length schematically indicates a speed of local airflow, the air flow redistribution device 14 redirects the airflow from regions of higher speed airflow discharged from the air multiplier 7 to regions of lower speed airflow discharged from the air multiplier 7, thereby promoting a more even distribution of airflow speeds downstream of the airflow redistribution device 14. Thus, in comparison to Fig. 3, the airflow, passed through the air multiplier 7 and then through the air flow redistribution device 14, becomes more uniform due to the configuration of the air flow redistribution device 14 that causes more even distribution of airflow speeds downstream of the airflow redistribution device 14. In this way, in contrast to existing arrangements as shown in Figs. 1 and 3, there are no longer regions of higher and lower speed airflow; rather, the airflow speeds are more evenly distributed around a plane that is substantially perpendicular to the first axis (A). As used herein, the term "substantially" is defined as being largely but not necessarily wholly what is specified, e.g., within 10% or within 1% or within 0.1% of what is specified, as understood by a person of ordinary skill in the art.

For example, substantially perpendicular includes perpendicular, and substantially coinciding includes coinciding.

As mentioned above, local airflow rates are generally more evenly distributed further away from the air flow generator 1. Thus, as shown in Fig. 3 by the broken-line arrows, airflow speeds, initially being higher in the regions closer the air flow generator 1, eventually become more evenly distributed as they reach the oil-to-air heat exchanger 11. For this to occur, the airflow generator 1 needs to be positioned at a certain distance, d3, from the transformer 10. However, in some implementations of transformer arrangements, attaining evenly distributed airflow speeds may not be possible, due to a prohibitively large distance at which the airflow generator is required to be positioned from the transformer for the air flow to become sufficiently evenly distributed around the area of the heat exchanger to cool the heat exchanger.

As shown in Fig. 4, the transformer arrangement 12 in accordance with the present disclosure allows having a reduced distance, d4, between the airflow generator 1 and the transformer 10 that allows the heat exchanger to receive a more evenly distributed air flow. This, the air flow generator 1 can be positioned closer to an object to be cooled by the airflow generated by the air flow generator 1, such as the oil-to-air external heat exchanger 11. This allows a reduction in a size of the transformer assembly 12. As a result, the air flow generator 1 and the oil-to-air external heat exchanger 11 may be positioned in a more compact arrangement of the components of the transformer assembly 12.

The air flow redistribution device 14 may have a central axis that substantially coincides with the first axis A. The airflow redistribution device 14 may comprise a ring-shaped profile extending around the first axis A. The ring-shaped profile, as used herein, covers any ring shape including circular rings and non-circular rings, such as rings comprising straight portions or a combination or curved and straight portions. For example, the air flow redistribution device 14 may have a square, pentagonal, hexagonal, or any other n-gonal cross-section. The air flow redistribution device 14 may form an open loop or a closed loop. A closed-loop configuration makes the device robust. The ring-shaped profile of the airflow redistribution device 14 may be formed by a single element or by multiple elements arranged to redistribute the air flow to equalize airflow speeds.

An airflow redistribution device in accordance with the present disclosure can have various designs. Figs. 6, 7a, 7b, 8a, 8b, 9a, and 9b illustrate non-limiting examples of the airflow redistribution device 14 in accordance with the present disclosure. Regardless of its specific configuration, the airflow redistribution device 14 redirects airflow from regions of higher speed airflow discharged from the air multiplier to regions of lower speed airflow discharged from the air multiplier, thereby promoting a more even distribution of airflow speeds downstream of the airflow redistribution device 14.

Fig. 6 illustrates the air multiplier 7 and an example of an airflow redistribution device 14a that comprises an array of air deflector members 15 distributed transversely to the first axis A such that the air deflector members 15 jointly define air passages between the air deflector members 15. The air deflector members 15 are configured such that a plurality of the air passages extend at an angle to the first axis A in the range of from 1 to 45 degrees.

The air deflector members 15 are distributed along the circumference of the airflow redistribution device 14a. In Fig. 6, the air deflector members 15 are rectangular-shaped plates. Plates are arranged in a stacked configuration such that each stack comprises a plurality of plates radially distributed with respect to the first axis A, wherein plates in a stack are disposed at an angle relative to plates in an adjacent stack. Five air deflector members in each stack are shown as an example only, since another suitable number of air deflector members may be arranged in a configuration as shown in Fig. 6. Also, the air deflector members 15 can have other shapes, including triangular, square, pentagonal, or another n-gonal shape.

The airflow redistribution device 14a shown in Fig. 6 comprises support means (not shown) configured to carry the air deflector members 15.

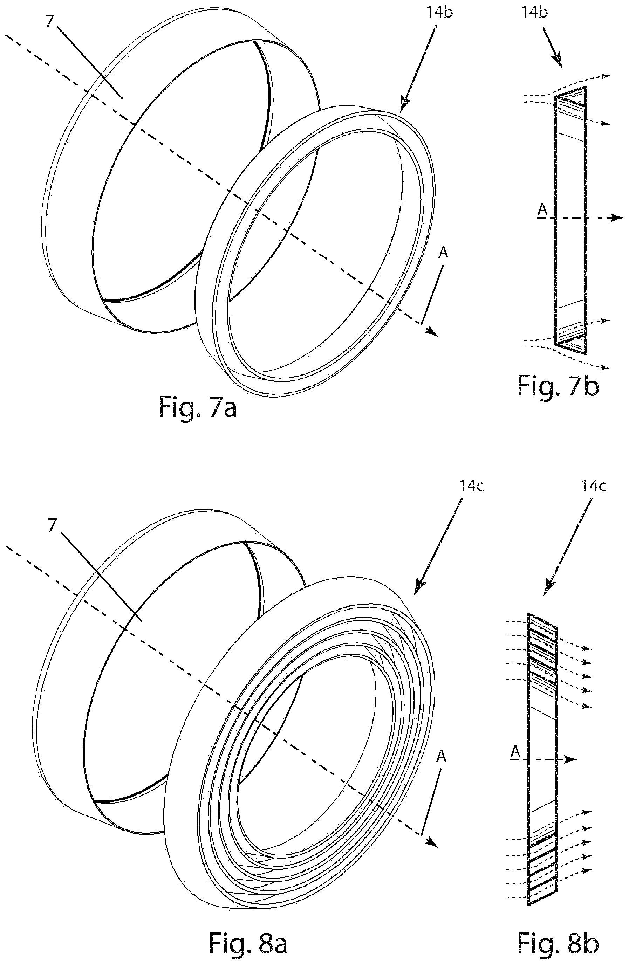

Fig. 7a illustrates the air multiplier 7 and an example of an airflow redistribution device 14b that comprises a single ring-shaped profile extending around the first axis A.

As shown in Fig. 7a, the airflow redistribution device 14b has a wedge-shaped cross-sectional profile, which in this embodiment is hollow, but in other embodiments could be solid. A leading portion of the wedge-shaped profile faces incoming air.

As shown by broken-lines arrows in Fig. 7b, the airflow discharged from the air multiplier 7 encounters the leading portion of the profile of the airflow redistribution device 14b and is diverted from its original direction by the curved walls of the airflow redistribution device 14b. This facilitates distribution of the airflow discharged from the air multiplier 7. The surfaces of the wedge-shaped profile are adapted to the indented air redistribution directions on a case-by-case basis.

The airflow redistribution device 14b, having a hollow profile, is more lightweight than a solid structure, which is advantageous for mounting and maintenance of a transformer arrangement. Also, manufacturing costs of the air flow generator 1 may be reduced due to a relatively simple configuration of the airflow redistribution device 14b.

Figs. 8a and 8b illustrate the air multiplier 7 and another example of an airflow redistribution device 14c that comprises a plurality of differently sized ring-shaped profiles extending around the first axis A. In this example, the airflow redistribution device 14c has five differently sized concentric rings in the form of hollow truncated cones. Each ring thus has a straight cross-sectional profile provided at an angle to the first axis A adapted to direct incoming air radially inwards with respect to the first axis A. The cross-sectional profiles are illustrated in Fig. 8b, along with broken-line arrows schematically illustrating redirection of incoming air. In other embodiments, the rings may be non-circular, yet using the same type of cross-sectional profile to redirect air.

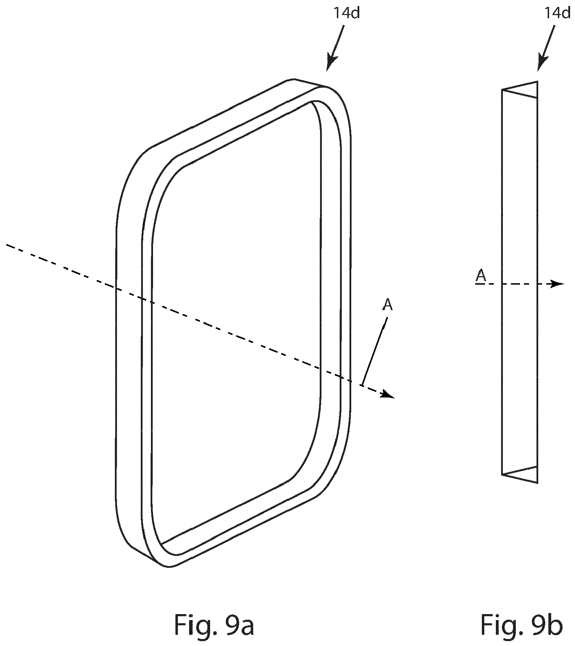

Fig. 9a illustrates an example of a configuration of an air flow redistribution device 14d having a square ring shape with rounded corners. As shown in Fig. 9b, the cross-sectional profile of the air flow redistribution device 14d is wedge-shaped similar to the embodiment of Figs. 7a-7b.

**Table of reference numerals**

| | |
|---|---|
| 1 | airflow generator |
| 2 | ducted fan |
| 3 | inlet of ducted fan |
| 4 | outlet of ducted fan |
| 5 | fluid conduit |
| 7, 7a | air multipliers |
| 8 | inlet of air multiplier |
| 9 | outlet of air multiplier |
| 10 | transformer |
| 11 | oil-to-air external heat exchanger |
| 12 | transformer arrangement |
| 14, 14a, 14b, 14c, 14d | airflow redistribution device |
| 15 | air deflector members |

## Claims

1. A transformer arrangement (12) comprising an airflow generator (1) and a transformer (10) provided with an oil-to-air external heat exchanger (11), the airflow generator (1) being configured to discharge air towards the oil-to-air heat exchanger (11), the airflow generator (1) comprising:
an electrically powered ducted fan (2) provided with an inlet (3) and an outlet (4),
a fluid conduit (5),
an air multiplier (7) for discharging air along a first axis (A), and
an airflow redistribution device (14, 14a, 14b, 14c, 14d) axially displaced from the air multiplier (7) along the first axis (A), downstream of the air multiplier (7);
the air multiplier (7) comprising an inlet (8) and an outlet (9);
the fluid conduit (5) fluidly connecting the outlet (4) of the ducted fan (2) to the inlet (8) of the air multiplier (7); and
the airflow redistribution device (14, 14a, 14b, 14c, 14d) being configured to redirect airflow from regions of higher speed airflow discharged from the air multiplier (7) to regions of lower speed airflow discharged from the air multiplier (7), thereby promoting a more even distribution of airflow speeds downstream of the airflow redistribution device (14, 14a, 14b, 14c, 14d).

2. The transformer arrangement (12) of claim 1, wherein the airflow redistribution device (14, 14a, 14b, 14c, 14d) comprises a ring-shaped profile extending around the first axis (A).

3. The transformer arrangement (12) of claim 1 or 2, wherein the airflow redistribution device (14, 14a, 14b, 14c, 14d) comprises a plurality of differently sized ring-shaped profiles extending around the first axis (A).

4. The transformer arrangement (12) of claim 3, wherein each ring-shaped profile has a diameter which is gradually decreasing in a discharge direction along the first axis (A).

5. The transformer arrangement (12) of claim 1, wherein the airflow redistribution device (14, 14a, 14b, 14c, 14d) comprises an array of air deflector members distributed transversely to the first axis (A) such that the air deflector members jointly define air passages between the air deflector members.

6. The transformer arrangement (12) of claim 5, wherein the air deflector members are configured such that a plurality of the air passages extend at an angle to the first axis (A) in the range of 1-45 degrees.

7. The transformer arrangement (12) of claim 5 or 6, wherein the air deflector members are rectangular-shaped plates.
